# EUROPÄISCHE PATENTSCHRIFT

(11) **EP 2 699 991 B1**
(45) Veröffentlichungstag und Bekanntmachung des Hinweises auf die Patenterteilung: **27.02.2019**
(21) Anmeldenummer: 12720409.7
(22) Anmeldetag: 18.04.2012
(51) Int. Cl.: G06F 3/044, G06F 3/041, H01L 27/32

(54) **OLED-INTERFACE**
OLED INTERFACE
INTERFACE OLED

(30) Priorität: 18.04.2011 DE 102011017383
(43) Veröffentlichungstag der Anmeldung: 26.02.2014
(73) Patentinhaber: Microchip Technology Germany GmbH & Co. KG, 82205 Gilching (DE); Ivanov, Artem, 82205 Gilching (DE)
(72) Erfinder: IVANOV, Artem, 82205 Gilching (DE)
(74) Vertreter: sgb europe
(86) Internationale Anmeldenummer: PCT/EP2012/001675
(87) Internationale Veröffentlichungsnummer: WO 2012/143126

(56) Entgegenhaltungen:
- EP-A1- 1 589 407
- WO-A1-2010/009655
- WO-A2-2009/095848
- WO-A2-2010/038179
- US-A1- 2010 110 041

## Beschreibung

### Gebiet der Erfindung

Die Erfindung richtet sich auf ein OLED-Interface, das bei Displayeinrichtungen, insbesondere von mobilen Kommunikationsgeräten, sowie als Hintergrundbeleuchtungsstruktur von Schaltfunktionsinteraktionszonen bei elektrischen Geräten, z.B. hinterleuchteten Bedienblenden, Anwendung finden kann.

### Hintergrund der Erfindung

Bislang als Beleuchtungsmittel eingesetzte OLEDs sind typischerweise aus mehreren organischen Schichten aufgebaut. Dabei wird meist auf die Anode, bestehend aus Indium-Zinn-Oxid (ITO), die sich auf einer Glasscheibe befindet, eine Lochleitungsschicht (engl. hole transport layer, HTL) aufgebracht. Zwischen ITO und HTL wird abhängig von der Herstellungsmethode oft noch eine Schicht aus PEDOT/PSS (Poly(3,4-ethylendioxythiophen)/Polystyrolsulfonat) aufgebracht, die zur Absenkung der Injektionsbarriere für Löcher dient und die Eindiffusion von Indium in den Übergang verhindert. Auf die HTL wird eine Schicht aufgebracht, die entweder einen Farbstoff enthält (ca. 5-10 %) oder - selten - vollständig aus dem Farbstoff (z. B. Aluminium-tris(8-hydroxychinolin), Alq3) besteht. Diese Schicht bezeichnet man als Emitterschicht (engl. emitter layer, EL). Auf diese wird dann eine Elektronenleitungsschicht (engl. electron transport layer, ETL) aufgebracht. Zum Abschluss wird eine Kathode, bestehend aus einem Metall oder einer Legierung mit geringer Elektronenaustrittsarbeit wie zum Beispiel Calcium, Aluminium, Barium, Ruthenium, Magnesium-Silber-Legierung, im Hochvakuum aufgedampft. Als Schutzschicht und zur Verringerung der Injektionsbarriere für Elektronen wird zwischen Kathode und ETL meistens eine sehr dünne Schicht aus Lithiumfluorid, Cäsiumfluorid oder Silber aufgedampft. Die Elektronen (= negative Ladung) werden nun von der Kathode injiziert, während die Anode die Löcher (= positive Ladung) bereitstellt. Loch und Elektron driften aufeinander zu und treffen sich im Idealfall in der EL, weshalb diese Schicht auch Rekombinationsschicht genannt wird. Elektronen und Löcher bilden einen gebundenen Zustand, der als Exziton bezeichnet wird. Abhängig vom Mechanismus stellt das Exziton bereits den angeregten Zustand des Farbstoffmoleküls dar, oder der Zerfall des Exzitons stellt die Energie zur Anregung des Farbstoffmoleküls zur Verfügung. Dieser Farbstoff hat verschiedene Anregungszustände. Der angeregte Zustand kann in den Grundzustand übergehen und dabei ein Photon (Lichtteilchen) aussenden. Die Farbe des ausgesendeten Lichts hängt vom Energieabstand zwischen angeregtem und Grundzustand ab und kann durch Variation der Farbstoffmoleküle gezielt verändert werden. Ein Problem stellen bislang nichtstrahlende Triplett-Zustände dar. Diese können durch Zugabe von sogenannten Exzitoren wieder gelöst werden. Für die aus Polymeren gefertigten organischen LEDs hat sich die Abkürzung PLED (engl. polymer light emitting diode) durchgesetzt. Als SOLED oder SMOLED werden seltener die aus "small molecules" (kleinen Molekülen) hergestellten OLEDs bezeichnet. In PLEDs werden als Farbstoffe häufig Derivate von Poly(p-Phenylen-Vinylen) (PPV) verwendet. In jüngster Zeit werden Farbstoffmoleküle eingesetzt, die eine vierfach höhere Effizienz als mit den oben beschriebenen fluoreszierenden Molekülen erwarten lassen. Bei diesen effizienteren OLEDs werden metall-organische Komplexe verwendet, bei denen die Lichtaussendung aus Triplett-Zuständen erfolgt (Phosphoreszenz). Diese Moleküle werden auch Triplett-Emitter genannt; der Farbstoff kann übrigens auch durch Licht angeregt werden, was zur Lumineszenz führen kann. Ziel ist es derzeit, selbstleuchtende Bildschirme herzustellen, die die organische Elektrolumineszenz nutzen. Ein Vorteil von OLED-Bildschirmen gegenüber den herkömmlichen Flüssigkristallbildschirmen ist der sehr hohe Kontrast, da sie ohne Hintergrundbeleuchtung auskommen: Während LCDs nur als farbige Filter wirken, emittieren OLEDs farbiges Licht. Dieses Verfahren ist deutlich effizienter, wodurch OLEDs weniger Energie benötigen. Aus diesem Grund werden OLED-TV-Geräte weniger warm als LC-Bildschirme, bei denen ein Großteil der für die Hintergrundbeleuchtung benötigten Energie in Wärme umgesetzt wird. Durch den geringen Energiebedarf können OLEDs gut in kleinen, tragbaren Geräten eingesetzt werden, beispielsweise Notebooks, Handys und MP3-Playern. Auf Grund der nicht benötigten Hintergrundbeleuchtung ist es möglich, OLEDs sehr dünn zu gestalten. OLED-Bildschirme und OLED-TV-Geräte schneiden aufgrund des geringeren Volumens sowie des deutlich geringeren Gewichts auch im Bereich Transportkosten deutlich besser als aktuelle LCD- und Plasma-Geräte ab. Aus einer Veröffentlichung des Fraunhoferinstituts ist ferner bekannt, ein OLED-Scheibenelement so zu gestalten, dass dieses durch Berührung an- und ausgeschaltet werden kann.

Weitere OLED Interfaces werden in den Patentschriften WO 2010/038179 A2, US 2010/0110041 A1, WO 2009/095848 A2 und EP 1589407 A1 beschrieben.

### Aufgabe der Erfindung

Der Erfindung liegt die Aufgabe zugrunde, Lösungen zu schaffen, durch welche in Verbindung mit OLED-Strukturen, eine Interaktionszone realisiert werden kann, die besonders vorteilhafte Interaktionsfunktionen bietet.

### Erfindungsgemäße Lösung

Die vorangehend genannte Aufgabe wird erfindungsgemäß gelöst durch ein OLED-Interface, wie in dem unabhängigen Anspruch 1 ausgeführt. Besondere Ausführungsbeispiele sind in den abhängigen Ansprüchen ausgeführt. Ein Verfahren zur Generierung von Eingabesignalen mittels dieser Vorrichtung wird in Anspruch 15 ausgeführt.

Dadurch wird es auf vorteilhafte Weise möglich, in Verbindung mit einer OLED-Struktur ein Anwenderinterface zu realisieren das es ermöglicht, die Bewegung eines Fingers oder einer Hand eines Anwenders in einem der OLED-Struktur vorgelagerten Bereich anhand elektrostatischer bzw. feldelektrischer Effekte zu erfassen und hierbei Rückgriff auf wenigstens ein Elektrodensystem der OLED-Struktur zu nehmen. Die diesbezüglich über die Auswertungsschaltung erfassten Orts- oder Bewegungsinformationen können zur Generierung von Maussteuersignalen, oder zur Generierung von anderweitigen Schalt- und Steuersignalen herangezogen werden.

Insbesondere ist es möglich, anhand der räumlichen Erfassung der Bewegung oder Position eines Fingers des Anwenders gegenüber der OLED-Struktur auch Steuerungsvorgänge abzuwickeln die unmittelbar die Funktion der OLED-Struktur betreffen. So kann die detektierte Bewegung dazu herangezogen werden, Gesten zu erkennen die ein Einschalten, ein Ausschalten und eine Helligkeitsregelung koordinieren, ohne dass die OLED-Struktur, oder eine diese beherbergende Gerätschaft physisch kontaktiert werden muss.

Die OLED-Struktur kann in Verbindung mit einer LCD- oder TFT-Struktur eine Displayeinrichtung bilden. Es ist möglich, eine der Elektrodenschichten der OLED-Strukktur - vorzugsweise die Anoden-Elektrodenschicht - als VCOM-Elektrode der LCD- oder TFT-Struktur zu verwenden.

Gemäß einem besonderen Aspekt der vorliegenden Erfindung ist die Anoden-Elektrodenschicht, die Kathoden-Elektrodenschicht, oder - bei Kombination der OLED-Struktur mit einer TFT-Struktur - eine auf der TFT-Struktur und hierbei auf einer der OLED-Struktur abgewandten Seite vorgesehene weitere Elektrodenschicht in eine in eine Vielzahl von Elektrodensegmenten derart untergliedert dass diese Elektrodensegmente hierbei ein Segmentarray bilden das Segmentzeilen und Segmentspalten umfasst. Die Auswertungsschaltung ist mit den Elektrodensegmenten gekoppelt und derart ausgebildet, dass diese einen Schaltungszustand einnehmen kann, in welchem über die Elektrodensegmente der Elektrodenschicht eine Positionserfassung bei Berührung abgewickelt wird, und weiterhin einen Schaltungszustand einnehmen kann, in welchem die berührungslose Positions- oder Bewegungserfassung eines Fingers des Anwenders in einem der O-LED-Struktur vorgelagerten Bereich abgewickelt werden kann.

Die Auswertungsschaltung kann weiterhin so ausgebildet sein, dass über diese ein Teil jener Elektrodensegmente die zur Detektion der Position des Fingers des Anwenders im Berührungsmodus herangezogen werden, auch zur Detektion im Nicht-Berührungsmodus herangezogen werden, wobei die berührungslose Positions- oder Bewegungserfassung erfolgt, indem mehrere Elektrodensegmente des Segmentarrays zu einer Elektrodengruppe zusammengefasst sind.

Dadurch wird es auf vorteilhafte Weise möglich, in Verbindung mit der OLED-Struktur eine Displayeinrichtung zu realisieren, wobei wenigstens ein Teil der Elektroden der OLED-Struktur zur Realisierung eines Sensorsystems herangezogen wird das einer Erfassung der räumlichen Positionen oder Bewegungen der Hand oder des Fingers eines Anwenders gegenüber der OLED-Struktur dient.

Die Elektrodensegmente können temporär als Elektrodensystem betrieben werden über welches eine Detektion der Position oder Bewegung eines Fingers des Anwenders abgewickelt wird, bevor dieser die OLED-Struktur berührt. Sobald eine Berührung der OLED-Struktur oder einer physischen Komponente einer die OLED-Struktur beinhaltenden Display- oder Leuchteinrichtung erfolgt, kann über unmittelbar benachbarte Elektrodensegmente bzw. benachbarte Elektrodensegmente von einander sich kreuzenden Zeilen und Spalten eine Positionsanalyse im Touch-Modus vorgenommen werden. Die Elektrodengruppe umfasst vorzugsweise Elektrodensegmente die in dem OLED-Interface eine gestreckte Kette bilden. Die zur Detektion der Fingerposition im Non-Touch-Modus herangezogenen Ketten erstrecken sich vorzugsweise relativ nahe entlang des Randbereiches der OLED-Struktur oder der diese umfassenden Displayeinrichtung. Die zur Positions- oder Bewegungserfassung temporär als Sensorelektrodensysteme betriebenen Segmentketten können zueinander verschiedene Ausrichtungen aufweisen, insbesondere zueinander parallel ausgerichtet und voneinander beabstandet sein. In die Positionsbestimmung können auch Auswertungsergebnisse einfließen die auf Detektionsereignissen beruhen welche aus zueinander quer verlaufenden, insbesondere zueinander senkrecht stehenden Elektrodensegmentketten erhoben wurden.

Die Detektion der Position eines Fingers bei Berührung der OLED-Struktur oder einer diese umfassenden Displayeinrichtung kann erfolgen, indem die feldelektrische Koppelung zweier unmittelbar benachbarter Elektrodensegmente erfasst und bewertet wird. Um diese kurze feldelektrische Zusammenkoppelung der benachbarten Elektrodensegmente zu detektieren ist das Segmentarray vorzugsweise so aufgebaut, dass eine erste Teilmenge der Elektrodensegmente zu separaten Segmentzeilen und eine zweite Teilmenge zu wiederum jeweils separaten Segmentspalten zusammengefasst sind. Die Segmentzeilen und die Segmentspalten sind gegeneinander isoliert. Die Verbindungsstege zwischen abfolgenden Elektrodensegmenten der jeweiligen Elektrodensegmentzeile sind gegenüber den Verbindungsstegen der abfolgenden Elektrodensegmente der Segmentspalten isoliert. Die entsprechenden Kreuzungspunkte sind als isolierende Brücken ausgebildet durch welche eine galvanische Verbindung dieser Verbindungsstege in dem Überquerungsabschnitt vermieden wird. Das Elektrodenarray ist vorzugsweise in der Art eines Feldes mit eng benachbarten Rauten, Sechsecken, Polygonen, oder anderweitigen engmaschig benachbarten Parzellen gebildet. Neben einem Elektrodensegment das Bestandteil einer Segmentspalte bildet befindet sich damit in unmittelbarer Nachbarschaft ein Elektrodensegment das Bestandteil einer Segmentzeile bildet. Der Berührungspunkt der OLED-Struktur oder eines diese umfassenden Displays entspricht damit dem Kreuzungspunkt derjenigen Segmentzeile und derjenigen Segmentspalte der die höchste kapazitive Koppelung bewirkt. Im Berührungserfassungsmodus erfolgt somit die Bestimmung der X- und Y- Positionen durch Erfassung der Kreuzungspunkte mit hoher kapazitiver Koppelung. Die Berührungsposition im Touch-Modus kann weiterhin auch erfasst werden, indem ermittelt wird, welche Segmentzeile und welche Segmentspalte die höchste kapazitive Koppelung mit dem Finger des Anwenders haben. Die Berührposition entspricht dann dem Kreuzungspunkt dieser Segmentzeile mit jener Segmentspalte. Im Non-Touchmodus hingegen erfolgt die Bestimmung der X- und Y- Positionen indem für die kapazitive Koppelung mehrerer Segmentspalten und mehrerer Segmentzeilen entsprechende, positionsabhängige Signalpegel erfasst werden, die indikativ sind für den Abstand des Fingers von der entsprechenden Segmentzeile und der entsprechenden Segmentspalte. Aus diesen Pegelwerten kann dann die Fingerposition errechnet werden, oder zumindest der Bewegungsverlauf des Fingers beschrieben werden. Diese Berechnung erfolgt vorzugsweise unter Abarbeitung mehrerer, vorzugsweise untereinander gewichteter Ansätze, beispielsweise von Triangulations- und Trilaterationsansätzen die auf verschiedene Elektrodensegmentgruppen und Gruppenkombinationen abgestimmt sind. Über die Segmentzeilen und Segmentspalten wird zunächst die kapazitive Koppelung gegen Ground, oder eine anderweitige Spannungseinkoppelung als analoger Pegel ermittelt. Dieser analoge Pegel wird dann über ein ADC-System konvertiert und einer digitalen Datenverarbeitung unterzogen.

Bei einer besonders bevorzugten Ausführungsform der Erfindung erfolgt bei einer im wesentlichen rechteckigen OLED-Struktur oder einer diese umfassenden Displayeinrichtung die Positions- oder Bewegungsbestimmung im Non-Touchmodus unter Verwendung der randnahen Segmentzeilen und Segmentspalten. Diese randnahen Segmentzeilen und Segmentspalten bilden dabei einen Elektrodenrahmen. Dieser Elektrodenrahmen ermöglicht es die X-Position des Fingers eines Anwenders durch Auswertung der durch den Finger beeinflussten kapazitiven Koppelung der randnahen Segmentspalten gegen Ground oder gegen ein Potential einer Elektrode der O-LED-Struktur zu ermitteln. Die Y-Position des Fingers kann anhand der durch den Finger beeinflussten kapazitiven Koppelung der oberen und der unteren horizontalen Segmentzeile gegen Ground oder gegen ein Potential einer Elektrode der OLED-Struktur ermittelt werden. Das Gegenpotential gegen Ground wird vorzugsweise an die als Anodenelektrode fungierende Elektrodenschicht der OLED-Struktur angelegt die sich im wesentlichen vollflächig auf einer dem Anwender abgewandten Rückseite des Scheibenlayers, d.h. auf der dem Anwender abgewandten Rückseite des Elektrodensegmentarrays erstreckt.

Vorzugsweise wird die Umschaltung zwischen einem ersten Schaltungszustand und einem zweiten Schaltungszustand durch eine Multiplexereinrichtung bewerkstelligt. Diese Multiplexereinrichtung kann als Zeitmultiplexereinrichtung ausgeführt werden die eine bestimmte Zeitphase für den Non-Touch-Modus und eine bestimmte Zeitphase für den Touch-Modus vorsieht. Ggf. können auch programmgesteuert bestimmte Gruppen von Elektrodensegmenten fortlaufend als Elektrodensegmentketten für die Positions- und Bewegungserfassung im Non-Touch-Modus herangezogen werden und parallel hierzu bestimmte Elektrodensegmentketten für eine zweidimensionale Positionserfassung im Touchmodus herangezogen werden. Die Benutzeroberfläche ist dann vorzugsweise so gestaltet, dass diese für jene Bereiche deren Elektrodensegmentketten zur Non-Touch-Positionsbestimmung herangezogen werden keine Touchdetektionsfunktion erfordert.

Touch-Detektionsmodus und Non-Touch-Detektionsmodus können durch schaltungstechnische Maßnahmen in zeitlicher Abfolge herbeigeführt werden, oder simultan präsent sein. Bei abfolgender Aktivierung kann anstelle einer starren Festlegung der Zeitdauer des jeweiligen Modus, der Wechsel zwischen dem jeweiligen Modus so abgestimmt werden, dass z.B. der Taktanteil für die Einnahme des zweiten Betriebszustands (des Non-Touch-Modus) auf Null gesetzt, oder reduziert wird, solange eine Berührung detektiert wird. Eine Berührung wird vorzugsweise erkannt, wenn die kapazitive Koppelung einer Elektrodensegmentzeile und einer Elektrodensegmentspalte miteinander, oder jeweils gegen Ground einen bestimmten Grenzwert überschreitet. Durch die Unterdrückung des Non-Touch Analysemodus kann die Signalverarbeitung vereinfacht werden, da die Signalauswertung im Touchmodus mit geringerer Sensibilität und einfacheren Auswertungsoperationen abgewickelt werden kann, als im Non-Touchmodus. Analog hierzu wird in vorteilhafter Weise der Taktanteil für die Einnahme des ersten Betriebszustands reduziert, solange keine Berührung detektiert wird. Da der Berührungsvorgang besonders zuverlässig erkannt werden kann, wird vorzugsweise jedoch selbst dann, wenn z.B. keine ein berührungsindikatives Grenzwertkriterium erfüllende Annäherung erkannt wird in bestimmten, jedoch vorzugsweise relativ großen Zeitabständen eine Berührungsdetektion durchgeführt um hierdurch einen Funktionssicherheitsgewinn zu erreichen.

Der Non-Toch-Modus kann in vorteilhafter Weise in zumindest zwei Sub-Modi untergliedert werden. Der erste Sub-Modus ist ein Large-Distance-Modus. In diesem wird z.B. nur eine Wake-UP-Funktion und eine grobe Erfassung eines Z-Achsen Abstandes (Abstand im wesentlichen senkrecht zum Display) durchgeführt. Erst bei Unterschreiten eines Mindestabstands in Z-Richtung erfolgt die Abarbeitung eines zweiten Sub-Modus. In diesem erfolgt eine sensiblere Positionsbestimmung durch Auswertung der Koppelung der durch die Elektrodensegmente gebildeten Elektrodengruppe gegen Ground oder Auswertung eines in diese Elektrodengruppe eingekoppelten Feldes. Der Grenzabstand bei dessen Unterschreiten eine Erfassung der X-, Y-, und Z-Position erfolgt entspricht beispielsweise einem Abstand bei welchem die randnahen Segmentzeilen und Segmentspalten bereits eine hinreichend genaue Positionsbestimmung ermöglichen. Diese Voraussetzungen sind gemäß experimenteller Untersuchung regelmäßig gegeben, wenn der Abstand des Fingers vom Display kleiner ist als etwa 2/3 der Displaydiagonalen.

Im Rahmen des zweiten Schaltzustandes, können bei Unterschreiten eines Mindestabstands verschiedene Elektrodensegmentgruppen sukzessive aktiviert werden. Die zur Positionserfassung im Non-Touch-Modus herangezogenen Elektrodensegmentzeilen und Elektrodensegmentspalten können damit im Display "wandern" und dabei für die jeweilige Fingerposition optimale Detektionspositionen einnehmen. Es können auch mehrere Elektrodensegmentzeilen und Elektrodensegmentspalten gleichzeitig aktiviert und ausgewertet werden. Die gleichzeitig aktivierten Elektrodensegmentgruppen können dabei voneinander beabstandete Zeilen bzw. Spalten, oder auch zueinander quer verlaufende Zeilen und Spalten sein. Für mittlere Abstände, d.h. Abstände von 25 bis 50% der Displaydiagonalen kann die Fingerposition durch Triangulatation und Trilateration, insbesondere durch Auswertung der analogen Signalpegel der randnahen Segmentzeilen und Segmentspalten ermittelt werden. Bei weiterer Annäherung kann die Fingerposition als Kreuzungspunkt derjenigen Segmentspalte und Segmentzeile mit der höchsten kapazitiven Koppelung gegen Ground, oder anderweitig signifikanten Potentialpegeln, vorzugsweise der OLED-Elektroden ermittelt werden. Der Z-Abstand kann dann aus dem jeweiligen Pegel der kapazitiven Koppelung gegen Ground, bzw. dem Potentialpegel ermittelt werden. Das Kreuzungspunktkonzept und das Trilaterationskonzept können auch miteinander verknüpft, insbesondere gewichtet verknüpft zur Positionsbestimmung herangezogen werden.

Vorzugsweise wird im zweiten Schaltzustand, d.h. dem Non-Touch-Modus eine erste Elektrodengruppe aktiviert, die eine obere randnahe horizontale Segmentkette darstellt und eine zweite Elektrodengruppe aktiviert, die eine untere randnahe horizontale Segmentkette darstellt. Durch diese beiden Elektrodensegmentgruppen kann dann die zwischen diesen horizontalen Grenzen liegende Y-Position des Fingers errechnet werden.

Zur Erfassung der X-Position im zweiten Schaltzustand (Non-Touch-Modus) werden vorzugsweise Elektrodengruppen herangezogen, die eine linke randnahe vertikale Segmentkette und eine rechte randnahe vertikale Segmentkette darstellen.

Weiterhin ist es möglich, sukzessive wechselnde Elektrodengruppen zur Erfassung der Fingerpositionen heranzuziehen, so dass beispielsweise die jeweils ausgewerteten Elektrodensegmentgruppen in der Art einer adaptiv durchgeschalteten, beispielsweise vertikal wandernden Zeile oder horizontal wandernden Spalte über das OLED-Interface, insbesondere OLED-Displayeinrichtung laufen.

Weiterhin können die Pegelwerte von zueinander quer, insbesondere zueinander in etwa senkrecht verlaufenden Elektrodensegmentketten durch entsprechende Auswertungskonzepte ausgewertet werden.

Die Erfassung der X-, Y-, und Z- Informationen erfolgt vorzugsweise indem wie bereits angesprochen im Rahmen des zweiten Schaltzustandes (Non-Touch-Modus) Elektrodengruppen gebildet werden und die Koppelung dieser Elektrodengruppen gegen Erde erfasst wird. Diese jeweilige Koppelung korreliert eng mit dem Abstand des Fingers von der jeweiligen Elektrodengruppe. Aus den jeweiligen Koppelungswerten gegen Erde, oder anhand einer anderweitigen, durch den Finger des Anwenders verursachten und mit dem Fingerabstand korrelierenden Potentialankoppelung kann dann der Abstand von der jeweiligen Elektrodengruppe ermittelt und die Position des Fingers aus den verschiedenen Abstandsinformationen erfasst werden.

Beispielhaft kann die Auswertungsschaltung als ASIC ausgeführt werden und in unmittelbarer Nähe des Scheibenlayers der OLED-Struktur angeordnet sein. Die Anbindung der Auswertungsschaltung an die diskreten Leiterbahnen der Elektrodensegmente kann beispielsweise durch eine flexible Leiterbahn, durch Klemmkontaktstrukturen (z.B. "Zebrastreifen") oder auch durch direkte Anordnung des ASIC's auf dem Scheibenlayer erfolgen. Die auf dem Scheibenlayer angeordneten Elektrodensegmente sind über Leitungsabschnitte mit dem ASIC verbunden. Bereits im Bereich des Scheibenlayers können vertikal und horizontal abfolgende Elektrodensegmente zu Elektrodenzeilen und Elektrodenspalten zusammengefasst sein, wobei diese Spalten und Zeilen gegeneinander isoliert und jeweils für sich als Elektrodensegmentgruppe an den ASIC oder einen Multiplexer angeschlossen sind.

Vorzugsweise sind die Elektrodensegmente als Kreisscheiben, als Rauten, Sechsecke, Achtecke, Mondsichelstrukturen oder eng benachbarte anderweitige Polygone ausgeführt, oder weisen teils ineinandergreifende Geometrien (z.B. sog. Knochen- oder Pflastersteinkontur) auf. Bei der Ausführung als entsprechende Segmente, insbesondere Rauten können Rautenketten gebildet werden. Ein Teil der Rauten wird zur Bildung horizontaler Rautenketten verwendet, der weitere Teil der Rauten wird zur Bildung vertikaler Rautenketten verwendet. Zwischen den Elektrodensegmenten verlaufen schmale Trenngassen die einen galvanischen Kontakt der Segmente einer Elektrodensegmentzeile mit den Elektrodensegmenten der kreuzenden Elektrodensegmentspalten verhindern. Die Elektrodensegmente sind also eng aneinander gedrängt ausgebildet, wobei nur die E-lektrodesegmente die eine zeilen- oder spaltenartige Kette bilden miteinander leitend verbunden sind.

Der ASIC ist intern vorzugsweise derart aufgebaut, dass dieser die Beschaltung der Elektrodensegmentzeilen und Elektrodensegmentspalten derart einstellt, dass diese sowohl zur Abarbeitung des Touch-Modus als auch zur Abarbeitung des Non-Touch-Modus entsprechend herangezogen werden können. Vorzugsweise ist in dem ASIC eine Einstellmöglichkeit vorgesehen die es ermöglicht, bestimmte Systemeigenschaften der Elektrodengruppen, sowie Übergangsphänomene beim Wechsel zwischen den Arbeitsmodi oder der Änderung des Gruppenaufbaus so zu berücksichtigen, dass diese hinreichend kompensiert werden.

Insbesondere für einhändig zu ergreifende Geräte wie z.B. Mobiltelefone ist es möglich, im Rahmen der Signalverarbeitung eine Kalibrierroutine abzuarbeiten durch welche zunächst eine durch den Geräteaufgriff verursachte Feldbeeinflussung zumindest weitgehend kompensiert wird. Die Gestenerfassung im Non-Touch-Modus kann zunächst eine bestimmte Geste, z.B. eine Bewegung der Fingerspitze entlang einer imaginären Kreisbahn im Uhrzeigersinn erfordern die in einem Abstand von etwa 66% der Displaydiagonalen vor dem Display durchgeführt wird. Mit dieser speziellen Geste kann der Non-Touch-Detektionsmodus aktiviert und zudem eine Kalibrierung der Sensorik durchgeführt werden.

Vorzugsweise wird über die Benutzeroberfläche eine mit der erfassten Position korrelierende Anzeige abgewickelt. Das Übergleiten bestimmter Fenster oder Menuepunkte in der grafischen Benutzeroberfläche kann akustisch, und vorzugsweise auch über eine mechanische Feedbackeinrichtung, z.B. elektromagnetisch verlagertes Masseelement haptisch vermittelt werden.

Soweit eine Annäherung des Fingers auch mit einem Aufsetzen auf das OLED-Display verbunden ist, können die in der Non-Touch-Annäherungsphase bestimmten Positionen mit der dann im Touch-Modus erfassten Berührungsposition verglichen werden. Anhand einer implementierten, internen Kalibrierprozedur können anhand der zunächst die Non-Touch-Phase erhobenen Informationen und anhand der im Touch-Modus extrem sicher erhobenen Positionsinformationen die Auswertungsparameter für nachfolgende Detektionsvorgänge adaptiert werden. Gleiches gilt auch für das Abheben des Fingers von der Displayeinrichtung. Hier kann anhand der letzen eindeutig bestimmten Berührungsposition für die Positionsbestimmung im Non-Touch-Modus eine automatische interne Feinjustierung durch entsprechende Modifikation interner Parameter bewerkstelligt werden.

Insbesondere bei relativ kleinformatigen Touchscreens kann die Positionserfassung so abgewickelt werden, dass bei größerem Fingerabstand von der Displayeinrichtung der Detektionsbereich zur Erfassung der Fingerposition größere Abmessungen hat als die Displayeinrichtung.

Die Verarbeitung der X- und Y- Positionen kann insbesondere in Y-Richtung derart erfolgen, dass hier ein Offset generiert wird, der dazu führt, dass der momentan im Display positionierte Cursor, oder der ausgewählte Menuepunkt nicht vom Finger des Anwenders verdeckt wird.

Unter Interface- oder Displayberührung ist im Kontext der vorliegenden Beschreibung ein leichtes Aufsetzen des Fingers auf eine OLED-Scheibenstruktur, insbesondere Displayscheibe zu verstehen. Die in das OLED-Interface eingebundenen Elektrodensysteme werden hierbei nicht, oder zumindest nicht zwingend galvanisch kontaktiert. Der Finger sitzt insoweit auf einem isolierenden Scheiben- oder Film-, oder Folienelement auf. Typischerweise sind sämtliche in dem OLED-Interface vorgesehenen Elektrodensysteme durch eine isolierende transparente Glas- oder Kunststoffschicht abgedeckt. Der Berührungszustand kann anhand diesbezüglich hinreichend indikativer Signalpegel erkannt werden. Der Berührungszustand und der Nicht-Berührungszustand können auch anhand besonderer, mit dem Z-Achsabstand einhergehende Dynamikmerkmale erkannt werden. So ist typischerweise beim Aufsetzen des Fingers die Z-Dynamik nahezu Null, oder repräsentiert die Abflachung der Fingerkuppe unter zunehmendem Aufsetzdruck. Dieses Phänomen kann als Selektionsindikator herangezogen werden. Auch die Z-Dynamik, bzw. bestimmte Z-Dynamikkriterien können im Non-Touchmodus als Selektionsindikator herangezogen werden. Ein Z-Dynamikkriterium kann beispielsweise so festgelegt sein, dass dieses bei einem raschen Absenken und wieder Anheben der Fingerkuppe über eine kurze, zum Display etwa senkrechte Strecke erfüllt wird. Dieses Z-Dynamikkriterium beschreibt dann einen "virtuellen Mausklick".

Die Benutzeroberfläche kann je nachdem, ob ein Touch-Mode, oder ein Non-Tochmode aktiv ist, variieren und hierbei Charakteristika aufweisen die für den jeweiligen Modus besondere Handhabungsvorteile bieten. So kann im Non-Touch-Modus ggf. eine gröbere grafische Meneuepunktgliederung, oder eine etwas trägere, oder schleppendere Cursordynamik vorgesehen sein, als im Touchmodus.

Auf Grundlage des erfindungsgemäßen Konzeptes ist es auch möglich, die jeweils quer und längs verlaufenden Elektrodensegmentketten so anzusteuern, dass durch diese eine Multipunkterkennung, insbesondere eine Erkennung von zwei Fingern ermöglicht wird. Es können hierzu beispielsweise mehrere Zonen generiert werden, die jeweils Werte für Fingerpositionen liefern. Die Aktivierung dieses Multipunktdetektionsmodus kann von der Erfüllung bestimmter Abstandskriterien, oder auch von bestimmten zunächst geforderten Bahnverläufen, d.h. Gesten abhängig sein. Im Rahmen eines Multipunktdetektionsmodus können intuitiv vorteilhaft koordinierbare Interaktionen wie beispielsweise Skalieroperationen, Rotationen von Bildinhalten und Drag and Drop Aktionen koordiniert werden, ohne dass hierbei das Display berührt wird.

Die Erfindung bezieht sich gemäß einem weiteren Lösungsgedanken auch auf eine hinterleuchtete Touchpadkomponente. Diese umfasst eine Trägerlage, eine OLED-Struktur und eine Elektrodenschicht, die an die Trägerlage angebunden ist. Die Elektrodenschicht ist in eine Vielzahl von Elektrodensegmenten untergliedert, wobei diese Elektrodensegmente hierbei ein Segmentarray bilden das Segmentzeilen und Segmentspalten umfasst. Die durch die OLED-Struktur erleuchtete Touchpadkomponente umfasst weiterhin eine Auswertungsschaltung die derart ausgebildet ist, dass diese einen Schaltungszustand einnehmen kann, in welchem über die Elektrodensegmente der Elektrodenschicht eine Berührungsdetektion abgewickelt wird. Zudem ermöglich die Auswertungsschaltung die Einnahme eines Schaltungszustandes in welchem eine berührungslose Positions- oder Bewegungserfassung eines Fingers des Anwenders in einem der Touchpadkomponente vorgelagerten Bereich abgewickelt werden kann. Die berührungslose Positions- oder Bewegungserfassung erfolgt unter Zusammenfassung mehrerer Elektrodensegmente des Segmentarrays zu einer zeilen- oder spaltenartigen Elektrodensegmentgruppe. Diese Touchpadkomponente kann konstruktiv wie vorangehend hinsichtlich der Displayeinrichtung beschrieben ausgestaltet werden. Diese Touchpadkomponente kann dazu verwendet werden um Touchpads zu realisieren die zudem auch eine berührungslose Positionserfassung ermöglichen. Derartige Touchpads können an bislang für Touchpads üblichen Einbaustellen z.B. in Notebooks verbaut werden. Die erfindungsgemäße Struktur zur kombinierten Erfassung von Fingerpositionen im Touch-Modus sowie auch im Non-Touchmodus kann auch in anderweitige Gerätschaften, insbesondere Möbel und Fahrzeuginnenausstattungen eingebunden werden um hier in einem räumlich begrenzten Bereich eine entsprechende Eingabezone, d.h. eine Eingabezone die auch Non-Touch Interaktionen ermöglicht, zu realisieren.

### Kurzbeschreibung der Figuren

Weitere Einzelheiten und Merkmale der Erfindung ergeben sich aus der nachfolgenden Beschreibung in Verbindung mit der Zeichnung. Es zeigt:
- **Figur 1**: eine Schemadarstellung zur Veranschaulichung des Aufbaus einer erfindungsgemäßen, unter Einschluss einer OLED-Struktur gebildeten ausgeleuchteten Positionssensoreinrichtung;
- **Figur 2**: eine Schemadarstellung zur Veranschaulichung des Aufbaues einer in Verbindung mit einer OLED-Struktur realisierten, beleuchteten Eingabeeinrichtung mit arrayartig angeordneten Elektrodensegmenten die sowohl zur Berührungsdetektion, als auch zur Fingerpositionserfassung im Non-Touch Modus herangezogen werden;
- **Figur 3**: eine Querschnittdarstellung zur weiteren Veranschaulichung des Aufbaues der beleuchteten Eingabeeinrichtung nach Figur 1;
- **Figur 4**: eine Schemadarstellung zur Veranschaulichung der Bildung von zwei horizontalen und zwei vertikalen Elektrodensegmentgruppen in einem Elektrodensegmentarray die temporär als Feldelektroden zur Erfassung einer Fingerposition herangezogen werden;
- **Figur 5**: eine Skizze zur Veranschaulichung der Ermittlung einer X-Koordinate durch Trilateration der durch die linken und rechten Segmentspalten erfassten Spannungspegel;
- **Figur 6**: ein Flussdiagramm zur Erläuterung einer vereinfachten Variante des erfindungsgemäßen Positionsbestimmungsverfahrens.

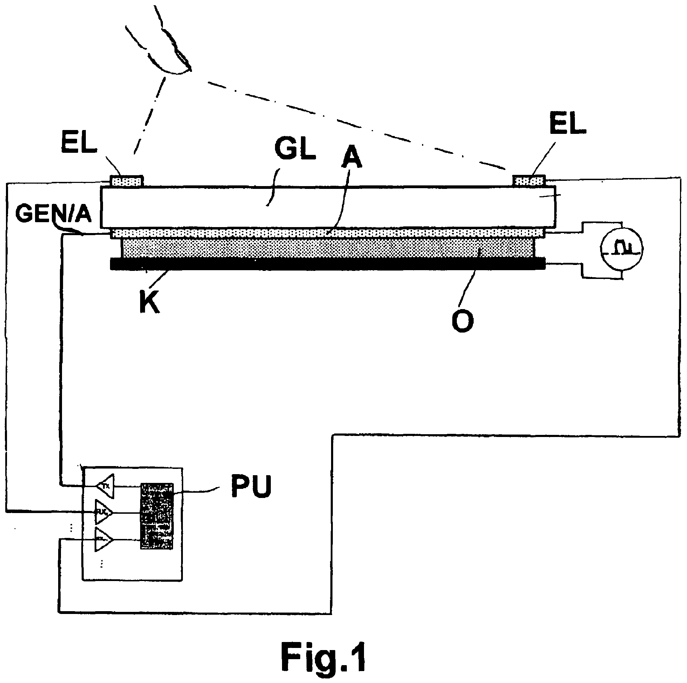

Figur 1 zeigt schematisch und stark vereinfacht den Querschnitt eines erfindungsgemäßen O-LED-Interfaces. Dieses umfasst einen Scheibenlayer GL, eine Anoden-Elektrodenschicht A, eine Kathoden-Elektrodenschicht K, und eine organische Leuchtmittelschichtstruktur O, die zwischen der Anoden-Elektrodenschicht A und der Kathoden-Elektrodenschicht K aufgenommen ist.

Das OLED-Interface umfasst weiterhin eine Auswertungsschaltung PU. Die Auswertungsschaltung PU ist derart ausgebildet, dass im Zusammenspiel mit wenigstens der Anoden-Elektrodenschicht A und/oder der Kathodenelektrodenschicht K (hier gezeigt die Variante mit Anodenschicht) ein Sensorsystem realisiert ist, zur Detektion eines Fingers F oder einer Hand eines Anwenders in einem dem Scheibenlayer GL vorgelagerten, Bereich bevor bzw. ohne dass dieser Anwender die OLED-Einrichtung, oder ein diese abdeckendes Scheibenelement berührt.

Durch den gezeigten Aufbau wird es wie eingangs bereits angegeben möglich, in Verbindung mit einer OLED-Struktur ein Anwenderinterface zu realisieren das es ermöglicht, die Bewegung eines Fingers F oder einer Hand eines Anwenders in einem der OLED-Struktur vorgelagerten Bereich anhand elektrostatischer bzw. feldelektrischer Effekte zu erfassen und hierbei Rückgriff auf die Elektroden der OLED-Struktur zu nehmen. Bei dem hier gezeigten Beispiel erfolgt die Spannungsversorgung der OLED-Struktur über einen Rechteckgenerator. Durch Pulsweitenmodulation kann die Leuchtintensität abgestimmt werden. Der Betrieb der OLED-Strukur mit alternierender Gleichspannung ermöglicht eine besonders vorteilhafte Betriebsweise des unter Einschluss der Anodenelektrode A realisierten Positionssensorsystems. So kann beispielsweise für jeden Spannungszyklus, oder für eine ausgewählte Anzahl von Spannungszyklen die Potentialeinkoppelung, kapazitive Koppelung gegen Ground, oder die kapazitive Koppelung gegen das Potential einer der Elektroden A, K der OLED-Struktur erfasst werden. Diese Pegel werden für die jeweilige Sensorelektrode EL ermittelt und zur Errechnung der Position des Fingers herangezogen.

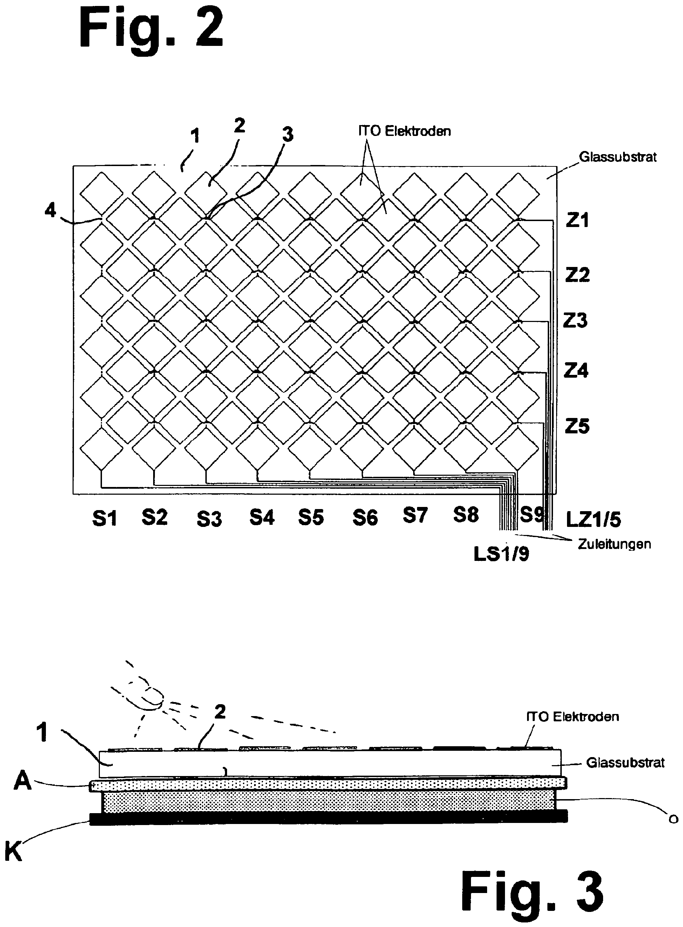

Figur 2 zeigt stark vereinfacht einen speziellen Anwendungsfall der erfindungsgemäßen OLED-Interface Technik bei einer Displayeinrichtung. Diese Displayeinrichtung umfasst einen Scheibenlayer 1 der aus einem transparenten und isolierenden Material besteht. Auf diesen Scheibenlayer 1 ist eine transparente Elektrodenschicht aufgebracht, die an den Scheibenlayer 1 angebunden ist. Diese Elektrodenschicht ist in eine Vielzahl von Elektrodensegmenten 2 untergliedert. Die Gemeinschaft aller Elektrodensegmente 2 bildet das hier erkennbare Segmentarray. Dieses Segmentarray bildet Segmentzeilen Z1, Z2, Z3, Z4 und Z5, sowie Segmentspalten S1, S2 .... S9 indem die entsprechend horizontal bzw. vertikal abfolgend benachbarten Segmente 2 durch kleine Verbindungsleitungsabschnitte 3, 4 miteinander verbunden sind. Die Segmentzeilen Z1... Z5 und die Segmentspalten S1... S9 sind gegeneinander isoliert und jeweils mit einer diskret über den Scheibenlayer geführten Zuleitung LZ1/5 und LS1/9 versehen. Die Verbindungsleitungsabschnitte 3, 4 sind - sofern diese sich im Bereich des Displays kreuzen, ebenfalls gegeneinander isoliert.

Über diese Zuleitungen LZ1/5 und LS1/9 sind die Segmentspalten und Segmentzeilen mit einer hier nicht näher gezeigten Auswertungsschaltung verbunden. Diese Auswertungsschaltung ist derart ausgebildet, dass diese einen ersten Schaltungszustand einnehmen kann, in welchem über die Elektrodensegmente der Elektrodenschicht eine Berührungsdetektion abgewickelt wird, und einen zweiten Schaltungszustand einnehmen kann, in welchem die berührungslose Positionserfassung eines Fingers des Anwenders in einem der Displayeinrichtung vorgelagerten Bereich abgewickelt werden kann, wobei die berührungslose Positionserfassung unter Zusammenfassung mehrerer Elektrodensegmente 2 des Segmentarrays zu einer Elektrodengruppe, insbesondere E-lektrodenzeile Z1 ...Z5 oder Elektrodenspalte S1 ...S9 erfolgt. Die Elektrodensegmente 2 oder die hieraus gebildeten Elektrodesegmentketten entsprechen funktional im wesentlichen den in Figur 1 gezeigten Sensorelektroden EL

In Figur 3 ist der Aufbau des OLED-Interfaces nach Figur 2 stark vereinfacht dargestellt. Der Scheibenlayer 1 besteht vorzugsweise aus einem Kunststoff-, oder Glasmaterial und hat eine Dicke von beispielsweise 0,8 mm. Auf den Scheibenlayer 1 ist auf beiden Seiten jeweils eine transparente leitfähige Beschichtung (z.B. ITO-Beschichtung) vorgesehen. Eine dieser Schichten fungiert als Elektrode der OLED-Struktur O. Vorzugsweise befindet sich die Anoden-Elektrodenschicht A zwischen dem die Elektrodensegmente 2 umfassenden Elektrodenarray und der Kathodenelektrodenschicht.

Die in Einbau- und Gebrauchsposition einem Anwender zugewandte Oberseite hat eine strukturierte und dabei in eine Vielzahl von Segmenten 2 untergliederte Schicht, die hierbei wie in Figur 2 skizziert in Reihen und Spalten gegliederte, eng benachbarte Segmente, z.B. Rauten aufweist. Die elektrische Kontaktierung der zu Reihen bzw. Spalten gruppierten Elektrodensegmente erfolgt über dezidierte Zuleitungen. Die als Anoden-Elektrode A der OLED-Struktur O fungierende Elektrode ist als durchgehende, transparente ITO-Schicht ausgeführt. Die so aufgebaute Scheibenstruktur bildet ein selbstleuchtendes Scheibenelement das als selbst leuchtendes Touchpad und als Interface für berührungslose Eingabeoperationen fungieren kann. Die Elektrodenschichten sind durch weitere, hier nicht gezeigte isolierend transparente Lagen abgedeckt und damit insbesondere von der Seite des Anwenders her nicht direkt galvanisch kontaktierbar.

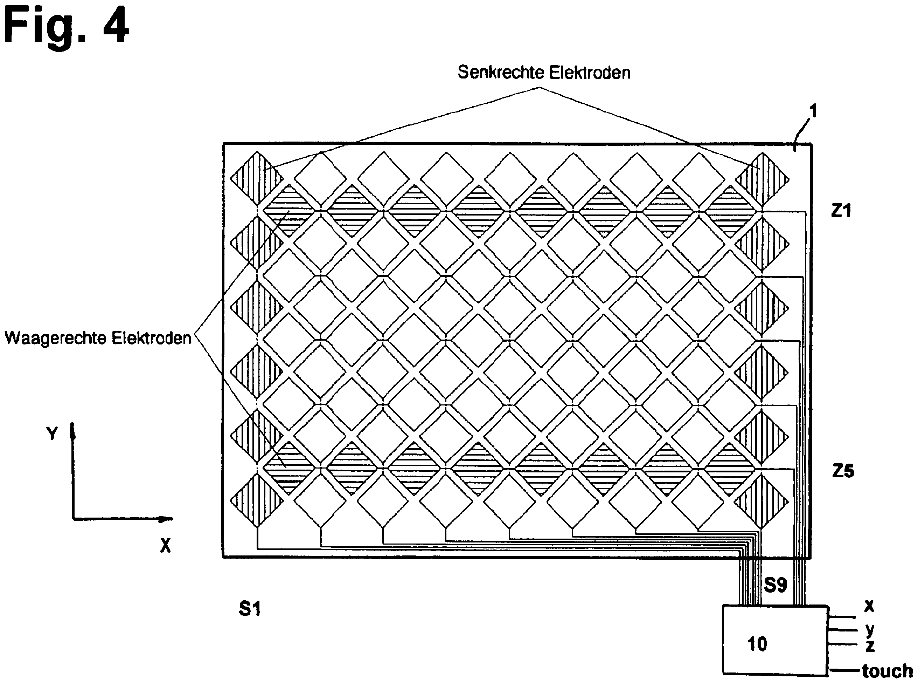

Wie in Figur 4 veranschaulicht, werden nunmehr bei dem hier gezeigten Ausführungsbeispiel in einem entsprechenden Schaltzustand, vier der randnahen Rautenstränge, d.h. die durch horizontalen Verbund von Elektrodensegmenten 2 gebildeten Segmentzeilen Z1 und Z5 sowie die durch vertikalen Verbund der randnahen Elektrodensegmente 2 gebildeten Segmentspalten S1 und S9 auf dem Glas für eine Fingerpositions- oder Fingerbewegungserfassung benutzt. Damit wird unter Nutzung der zu Zeilen und Spalten gruppierten Elektrodensegmente ein "Rahmen" mit Gestenerfassungselektroden aufgebaut.

Die obere horizontale Elektrodensegmentgruppe Z1 und die untere horizontale Elektrodensegmentgruppe Z2, sowie die beiden randnahen linken, bzw. rechten Elektrodensegmentspalten S1 und S9 die im Non-Touch-Modus zur Fingerpositionserfassung herangezogen werden sind hier durch Schraffur hervorgehoben. Die beiden horizontalen Elektrodensegmentgruppen Z1 und Z5 werden zur Erfassung einer Y-Position des Fingers eines Anwenders herangezogen. Simultan zur, oder ggf. auch unmittelbar nach der über diese beiden Elektrodensegmentgruppen Z1 und Z5 bewerkstelligten Detektion der Y-Position kann eine Auswertung erfolgen durch welche über die Elektrodensegmentspalte S1 im linken Randbereich eine linke lang gestreckte Detektionselektrode gebildet wird (linke vertikale Rautenkette) und durch Zusammenschalten der Elektrodensegmente im rechten Randbereich eine rechte Elektrodensegmentspalte S9 (rechte vertikale Rautenkette) gebildet wird. Über diese beiden Elektrodengruppen kann dann die X-Position des angenäherten Fingers ermittelt werden. Weiterhin kann aus den Messsignalen der Abstand des Fingers von dem OLED-Interface ermittelt werden. Zur Bestimmung der X- und Y-Positionen können auch die von den zeilen- und spaltenartigen Elektrodensegmentgruppen erfassten Signalpegel auf Grundlage anderweitiger Auswertungsansätze bestimmt werden. Insbesondere können für die X- und Y-Positionsbestimmung auch zueinander quer verlaufende Elektrodensegmentgruppen herangezogen werden. Zur Bestimmung der X- und Y- Positionen können verschiedene Auswertungsansätze gewichtet kumuliert herangezogen werden.

In einem Gerät das mit einem entsprechenden OLED-Interface ausgestattet ist, kann die Positionierung der Hand oder eines Fingers ab Unterschreiten eines bestimmten Abstands erfasst werden bevor dieser das OLED-Interface berührt. Sobald der Finger des Anwenders auf dem OLED-Interface aufsitzt, wird unter Nutzung der Elektrodensegmente 2 eine an sich bekannte Touchpadfunktion geboten.

Es ist möglich, im Bereich des OLED-Interfaces weitere Elektroden vorzusehen, die beispielsweise nur der Unterstützung der Positionserfassung im "Non-Touch-Mode" dienen. Durch diese zusätzlichen Elektroden kann beispielsweise die Präsenzerfassung einer Hand bei einem größeren Abstand bewerkstelligt werden. Ein Wechsel in einen Betriebsmodus in welchem die Touch-Analyse Elektroden als Positionserfassungselektroden für berührungslose Positionserfassung verwendet werden erfolgt dann z.B. erst, wenn ein bestimmter Mindestabstand unterschritten ist. Die Durchführung einer Positionserfassung von Fingern bevor diese das OLED-Interface berühren kann unterdrückt werden, sobald eine Berührung des OLED-Interfaces erkannt wurde. Weiterhin kann die Auswertung der Elektrodensegmente im Berührungsmodus unterdrückt werden, solange ein bestimmter Mindestabstand noch nicht unterschritten wird.

Der Fingerpositionserfassungsmodus ohne Kontaktierung (Non-Touch- oder GestIC-Modus) und der Fingerpositionserfassungsmodus mit Interfaceberührung (Touch-Modus) können durch einen Multiplexer, insbesondere Zeitmultiplexer jeweils angeschaltet werden. Der GestIC-Modus kann die Anwendung eines zur Auswahl der jeweiligen Elektrodengruppe vorgesehenen Group-Drivers beinhalten, wobei durch jenen Group-Driver festgelegt wird, welche Elektrodensegmentgruppe, oder ggf. sogar welche einzelnen Elektrodensegmente momentan zur Erfassung der Fingerposition im Non-Touchmodus herangezogen wird. Der Group-Driver kann die Informationen zur momentanen Elektrodensegmentgruppe an eine Kompensationsschaltung weiterleiten die als solche bestimmte Kennwerte oder Voreinstellungen und Bezugspegelwerte festlegt die bei der Auswertung der über die jeweilige Elektrodensegmentgruppe erfassten feldelektrischen Phänomene Berücksichtigung finden. Diese Kennwerte können insbesondere die Gesamtkapazität oder Normalerdung des momentan aktiven Elektrodensystems in unbeeinflusstem Zustand beschreiben und damit eine bestimmte Vorkalibrierung bewirken.

Die Schaltung zur temporären Aktivierung der Elektrodensegmentzeilen und Elektrodensegmentspalten, sowie zur Auswertung der über die aktivierten Elektrodensegmentgruppen detektierten feldelektrischen Umgebungszustände kann in vorteilhafter Weise in einem ASIC 10 implementiert sein, der vorzugsweise in unmittelbarer Nähe des Scheibenlayers 1 angeordnet, insbesondere an den Scheibenlayer 1 angebunden ist. Dieser ASIC 10 ist vorzugsweise derart ausgebildet, dass dieser neben der Erfassung der Fingerposition im Non-Touch-Modus auch die Aswertung im Touchmodus, d.h. die Touchscreenfunktionalität bietet. Dieser ASIC 10 ist vorzugsweise so ausgelegt, dass bestimmte Funktionen desselben durch Programmierung festgelegt werden können. Der ASIC kann so gestaltet sein, dass durch diesen festgelegt wird, welche Elektrodensegmentgruppen, insbesondere welche Elektrodensegmentzeilen Z1...Z5 und Elektrodensegmentspalten S1...S9 des Elektrodensegmentarrays für die Positionserfassung im Non-Touchmodus momentan herangezogen werden.

Der ASIC 10 selbst liefert die Signale bezüglich der X- und Y- Position sowie des Touchzustandes in der Art verbreiteter Touchscreen-Schaltungen. Zusätzlich liefert der ASIC 10 auch die Z-Position bzw. Signale die Rückschlüsse auf den Abstand des Fingers eines Anwenders von dem Display geben bevor dieses berührt wird. Im ASIC kann ein Hintergrundprogramm abgearbeitet werden dass eine bestimmte Vorauswertung der erfassten Positions- oder Bewegungsinformationen vornimmt. So können durch den ASIC insbesondere auch "Mausklick-Informationen" generiert werden. Der ASIC 10 nutzt die zur X- und Y- Positionserfassung im Touch-Modus vorgesehenen Elektrodensegmente 2 und wählt aus diesen phasenweise Elektrodensegmentgruppen Z1...Z5 und S1...S9. Diese Elektrodensegmentgruppen Z1...Z5 und S1...S9 werden an ein Auswertungssystem angebunden. Durch dieses Auswertungssystem kann der Abstand, d.h. die Z-Position des Fingers, oder der Hand eines Anwenders vom OLED-Interface erfasst werden. Die Erfassung beruht hierbei auf einer Änderung der kapazitiven Koppelung gegen Erde (Ground), der Einkoppelung eines Potentiales, und/oder der Änderung der dielektrischen Eigenschaften der Umgebung der Elektrodengruppen infolge des Eindringens und Positionierens des Fingers oder der Hand in einem dem OLED-Interface vorgelagerten Bereich. Die Beeinflussung der dielektrischen Eigenschaften der Umgebung der Elektrodensegmentgruppen Z1...Z5 und S1...S9 durch den Anwender kann über die temporär als Sensorelektroden betriebenen Elektrodengruppen durch verschiedene Messansätze erfasst werden. Ein typischer Messansatz besteht darin, dass beispielsweise die durch den Finger des Anwenders beeinflusste Koppelung der aktivierten Elektrodensegmentgruppe gegen Ground als analoger, d.h. innerhalb eines Bereiches variierender Pegel erfasst wird.

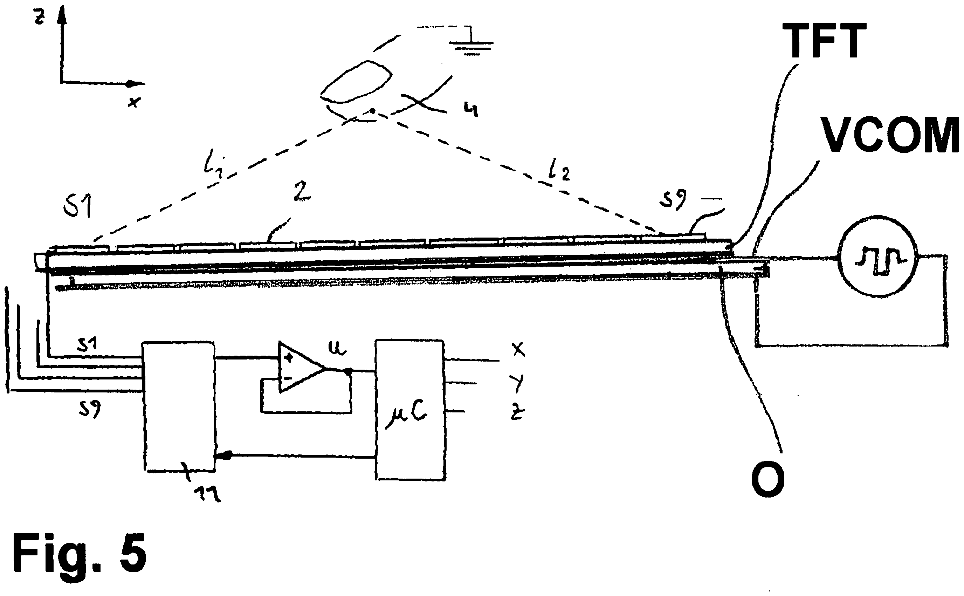

In Figur 5 ist in Form einer Skizze ein erfindungsgemäßes OLED-Interface und die hiermit abgewickelte Erfassung der Position eines Fingers eines Anwenders weiter veranschaulicht. Über die randnahen und zu Segmentspalten S1 und S9 zusammengefassten Elektrodensegmente 2 werden Signalpegel erfasst, die indikativ sind für die Abstände 11, 12 der Fingerkuppe 4 des Anwenders von dem OLED-Interface. Aus diesen Signalpegeln wird dann die X-Position und der Z-Abstand errechnet. Die Pegelerfassung erfolgt über einen Groupdriver der sukzessive bestimmte Elektrodensegmentgruppen der Displayeinrichtung mit einer Auswertungsschaltung verbindet. Hier wird über den vereinfacht dargestellten Verstärker der Spannungspegel an der Elektrodengruppe hochohmig erfasst und dem µC zugeführt. Dieser umfasst einen ADC und errechnet aus den so gewonnenen digitalen Pegelinformationen die X-, Y- und Z-Koordinaten der Fingerkuppe 4. Die Elektrodensegmente 2 sitzen auf einem Scheibenlayer der Teil einer TFT-Displaystruktur bildet. Die TFT-Displaystruktur umfasst eine VCOM-Elektrode (VCOM) die unmittelbar als Anodenelektrode, oder ggf. auch als Kathode der OLED-Struktur O fungiert. Die OLED-Struktur O, die TFT-Strukur TFT und das obere Sensorelektrodenarray haben einen Schichtaufbau. Die OLED-Struktur O und die TFT-Struktur TFT teilen sich eine transparente Elektrodenschicht als VCOM Elektrode bzw. als Anodenelektrode der OLED-Struktur. Die TFT-Struktur kann auch als einfache LCD-Struktur ausgeführt sein.

An den Elektroden der OLED-Struktur O liegt eine hier vereinfacht als Rechteckspannung beschriebene alternierende Spannung ohne Potentialumkehr an. Die Schaltungsanordnung umfasst RX und TX Anschlüsse. Es ist möglich, z.B. durch entsprechenden Kanalmultiplex eine Vielzahl von Elektrodensegmentketten zur berührungslosen Positionsbestimmung heranzuziehen. Die Auswertung der an den jeweiligen Elektrodensegmentketten im Non-Touch-Modus anliegenden Signalpegel kann so abgewickelt werden, dass eine Multiobjekterkennung, d.h. z.B. die Erkennung von zwei Fingerspitzen und eine entsprechende Positionserkennung erfolgt.

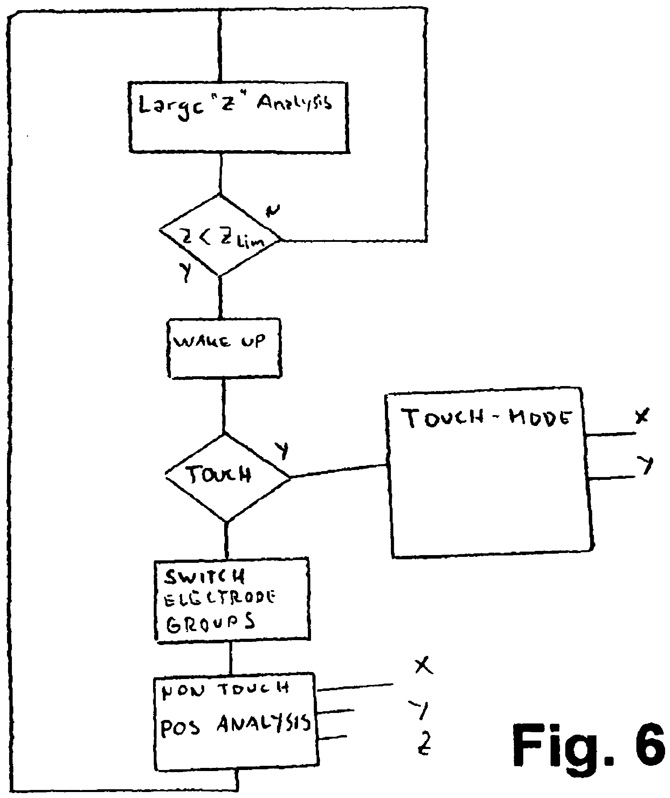

In Figur 6 ist ein vereinfachtes Flussdiagramm dargestellt. Wie hieraus ersichtlich, wird zunächst geprüft, ob ein bestimmter Mindestabstand von der OLED-Struktur unterschritten wird. Trifft dies zu, so wird das System aus einem einfachen Energiesparbetriebsmodus in einen Hauptbetriebszustand umgeschaltet. Wird ein Touchzustand festgestellt, so wird über das Elektrodensegmentarray eine Erfassung der Berührungsposition abgewickelt. Dieser Touch-Modus wird solange beibehalten, bis die Berührung beendet wird. Sobald der Finger des Anwenders vom OLED-Interface abhebt, wird überprüft, ob noch ein bestimmter Abstandsschwellwert von z.B. 66 % Interfaceflächendiagonale nicht überschritten wird. Wird dieser Abstandsschwellwert nicht überschritten arbeitet das Detektionssystem im Non-Touch-Modus in welchem sukzessive aktivierte Elektrodensegmentzeilen Z1... Z5 und Elektrodensegmentspalten S1... S9, oder nur die randnahen Elektrodensegmentgruppen, d.h. die Elektrodensegmentzeilen Z1 und Z5, sowie die Elektrodensegmentspalten S1 und S9 des Elektrodensegmentarrays hinsichtlich ihrer kapazitiven Koppelung gegen Ground untersucht werden. Aus den von der momentanen Fingerposition abhängigen Analogwerten können die X, Y und Z-Positionen des Fingers errechnet werden.

Die erfindungsgemäße Technik kann in vorteilhafter Weise als OLED-Scheibenelement realisiert werden, das mit Touchscreen-Elektroden ausgestattet ist, wobei diese Touchscreen-Elektroden an eine erfindungsgemäße Auswertungsschaltung angebunden sind. Dieses Scheibenelement kann dann in ein Display eingebunden werden. Die Elektroden des Scheibenelementes sind vorzugsweise auf der dem Anwender zugewandten Seite nochmals von einer isolierenden transparenten Decklage abgedeckt, so dass auch im Touch-Modus keine galvanische Kontaktierung der Elektrodensegmente erfolgt.

Die erfindungsgemäße Technik eignet sich insbesondere für mobile Kommunikationsgeräte wie Mobiltelefone, e-books und Tablet-PC's.

Die Elektrodensegmente des Elektrodenarrays können in eine mehrschichtige transparente Scheibenstruktur eingebunden sein. Um eine besonders zuverlässige Isolierung der sich kreuzenden Überbrückungspunkte zwischen den einzelnen Elektrodensegmenten zu erreichen, können die Elektrodensegmente die jeweils Elektrodensegmentzeilen bilden auf einer ersten Seite eines transparenten und isolierenden Layers angeordnet sein und diejenigen Elektrodensegmente die zu Elektrodensegmentspalten verbunden sind- also quer zu den Zeilen verlaufen - auf einer abgewandten Seite dieses Layers, oder auch auf einem weiteren Layer angeordnet sein. Weiterhin kann auf der dem Anwender später abgewandten Seite dieser Sandwichstruktur eine im wesentlichen vollflächige Rückabschirmungslage ausgebildet sein. Diese Rückabschirmungslage kann insbesondere auch durch die sog. VCOM-Lage einer Flüssigkristallstruktur gebildet sein. Diese wiederum fungiert vorzugsweise als Elektrode der OLED-Struktur.

Die vorliegende Erfindung richtet sich primär auf ein OLED-Interface das sowohl Touchscreenfunktionalitäten, als auch Non-Touch-Positionsanalyse Funktionalitäten bietet, wobei diese Funktionalitäten durch gemeinsam genutzte Elektrodensegmente realisiert werden. Das erfindungsgemäße Konzept ist auch auf Flachstrukturen übertragbar die nicht unmittelbar ein Display bedecken. Diese Flachstrukturen können dazu verwendet werden um zumindest temporär beleuchtete Touchpads zu realisieren die zudem auch eine berührungslose Positionserfassung ermöglichen. Derartige Touchpads können an bislang für Touchpads üblichen Einbaustellen z.B. in Notebooks verbaut werden. Die erfindungsgemäße Struktur zur kombinierten Erfassung von Fingerpositionen im Touch-Modus sowie auch im Non-Touchmodus kann auch in anderweitige Gerätschaften, insbesondere Möbel und Fahrzeuginnenausstattungen eingebunden werden um hier in einem räumlich begrenzten Bereich eine entsprechende, temporär beleuchtete Eingabezone, d.h. eine Eingabezone die auch Non-Touch Interaktionen ermöglicht, zu realisieren.

## Patentansprüche

1. OLED-Interface, mit:
- einem Scheibenlayer (GL),
- einem auf einer ersten Seite des Scheibenlayers (GL) angeordneten OLED Display aufweisend:
- einer Anoden-Elektrodenschicht (A),
- einer Kathoden-Elektrodenschicht (K), und
- einer organischen Leuchtmittelschichtstruktur (O) die zwischen der Anoden-Elektrodenschicht (A) und der Kathoden-Elektrodenschicht (K) aufgenommen ist, wobei das OLED Display über eine der Anodenschicht (A) und der Kathodenschicht (K) zugeführte pulsweitenmodulierte Gleichspannung betrieben wird,
- einer Sensorelektrodenanordnung mit einer Vielzahl von Empfangselektroden (EL) welche auf einer der ersten Seite gegenüberliegenden Seite des Scheibenlayer (GL) angeordnet sind; undeiner Auswertungsschaltung (PU; 10) welche mit den Empfangselektroden (EL) gekoppelt ist,
- **dadurch gekennzeichnet, dass** die Auswertungsschaltung (PU; 10) derart ausgebildet und angeschlossen ist, dass im Zusammenspiel mit wenigstens der Anoden-Elektrodenschicht (A) und/oder der Kathodenelektrodenschicht (K) ein Sensorsystem realisiert ist, wobei eine Potentialeinkopplung der dem OLED Display (A, O, K) zugeführte pulsweitenmodulierte Gleichspannung über die Empfangselektroden (EL) gemessen wird und zur berührungslosen Detektion eines Fingers (4) oder einer Hand eines Anwenders in einem dem Scheibenlayer (GL) vorgelagerten Bereich dient.

2. OLED-Interface nach Anspruch 1, **dadurch gekennzeichnet, dass** die Positionsbestimmung durch Auswertung von Spannungspegeln bewerkstelligt wird, wobei diese Spannungspegel zwischen einer der Elektrodenschichten (A, K) und einer Sensorelektrodenanordnung (EL) mittels einer hochohmigen Verstärkerschaltung gemessen werden.

3. OLED-Interface nach Anspruch 1, **dadurch gekennzeichnet, dass** die Positionsbestimmung durch Auswertung von Spannungspegeln bewerkstelligt wird, wobei diese Spannungspegel zwischen der Anoden-Elektrodenschicht (A) und einer Sensorelektrodenanordnung (EL, 2) mittels einer hochohmigen Verstärkerschaltung gemessen werden.

4. OLED-Interface nach einem der vorhergehenden Ansprüche, wobei die Sensorelektrodenanordnung in eine Vielzahl von Elektrodensegmenten (2) untergliedert ist und diese Elektrodensegmente (2) hierbei ein Segmentarray bilden das Segmentzeilen und Segmentspalten umfasst,

5. OLED-Interface nach Anspruch 4, **dadurch gekennzeichnet, dass** die Auswertungsschaltung (10) derart ausgebildet ist, dass diese einen Schaltungszustand einnehmen kann, in welchem über die Elektrodensegmente (2) der Elektrodenschicht eine Berührungsdetektion abgewickelt wird.

6. OLED-Interface nach Anspruch 5, **dadurch gekennzeichnet, dass** eine Umschaltung zwischen dem Schaltungszustand zur Positionserfassung bei Berührung und dem Schaltzustand zur Positions- oder Bewegungserfassung ohne Berührung durch eine Multiplexereinrichtung bewerkstelligt wird.

7. OLED-Interface nach Anspruch 6, **dadurch gekennzeichnet, dass** der Taktanteil für die Einnahme des Betriebszustands zur Positions- oder Bewegungserfassung ohne Berührung auf Null gesetzt, oder reduziert wird, solange eine Berührung detektiert wird.

8. OLED-Interface nach Anspruch 6 oder 7, **dadurch gekennzeichnet, dass** der Taktanteil für die Einnahme des Betriebszustands zur Positionsbestimmung bei Interfacekontaktierung reduziert wird, solange keine Berührung detektiert wird und/oder dass im Rahmen des zur Positions- oder Bewegungserfassung ohne Berührung vorgesehenen Schaltzustandes zunächst eine grobe Annäherungsdetektion abgewickelt wird, und dass erst bei Erfassung eines hinreichend ausgeprägten Näherungszustandes eine sensiblere Positionsbestimmung abgewickelt wird.

9. OLED-Interface nach wenigstens einem der Ansprüche 1 bis 8, **dadurch gekennzeichnet, dass** im Rahmen des zur Positions- oder Bewegungserfassung ohne Berührung vorgesehenen Schaltzustandes wechselnde Elektrodensegmentgruppen (S1..S9; Z1..Z5) als Sensorelektroden (EL) fungieren.

10. OLED-Interface nach wenigstens einem der Ansprüche 1 bis 9, **dadurch gekennzeichnet, dass** im Rahmen des zur Positions- oder Bewegungserfassung ohne Berührung vorgesehenen Schaltzustandes zur Ermittlung einer Y-Position eine Elektrodensegmentgruppe (Z1) aktiviert wird, die eine obere horizontale Segmentkette darstellt und/oder dass im Rahmen des zur Positions- oder Bewegungserfassung ohne Berührung vorgesehenen Schaltzustandes zur Ermittlung einer Y-Position eine Elektrodensegmentgruppe (Z5) aktiviert wird, die eine untere horizontale Segmentkette darstellt.

11. OLED-Interface nach wenigstens einem der Ansprüche 1 bis 10, **dadurch gekennzeichnet, dass** im Rahmen des zur Positions- oder Bewegungserfassung ohne Berührung vorgesehenen Schaltzustandes zur Ermittlung einer X-Position eine Elektrodensegmentgruppe aktiviert wird, die eine linke vertikale Segmentkette (S1) darstellt und eine Elektrodensegmentgruppe aktiviert wird, die eine rechte vertikale Segmentkette (S9) darstellt.

12. OLED-Interface nach wenigstens einem der Ansprüche 1 bis 11, **dadurch gekennzeichnet, dass** im Rahmen des zur Positions- oder Bewegungserfassung ohne Berührung vorgesehenen Schaltzustandes zur Ermittlung einer X- und Y-Positionen auf Pegelwerte Rückgriff genommen wird die von zueinander quer ausgerichteten, insbesondere zueinander senkrecht stehenden Elektrodensegmentgruppen erhoben werden.

13. OLED-Interface nach wenigstens einem der Ansprüche 1 bis 12, **dadurch gekennzeichnet, dass** die zur Erfassung der Fingerposition im Non-Touch-Modus herangezogenen Elektrodensegmentgruppen (Z1 ...Z5; S 1 ...S9) adaptiv ausgewechselt werden, z.B. sukzessive derart durchgewechselt werden, dass die jeweils aktive Elektrodensegmentgruppe (ZI ...Z5; S 1 ...S9) in der Art einer laufenden Zeile oder laufenden Spalte über das Interface wandert.

14. OLED-Interface nach wenigstens einem der Ansprüche 1 bis 13, **dadurch gekennzeichnet, dass** im Rahmen des zur Positions- oder Bewegungserfassung ohne Berührung vorgesehenen Schaltzustandes jeweils zwei Elektrodensegmentgruppen gebildet werden und die kapazitive Koppelung dieser beiden Elektrodensegmentgruppen erfasst wird, und aus dieser kapazitiven Koppelung der Näherungszustand ermittelt wird.

15. Verfahren zur Generierung von Eingabesignalen im Zusammenhang mit der Bewegung eines Fingers eines Anwenders mittels eines OLED-Interfaces gemäß einem der vorhergehenden Ansprüche, mit den Schritten:
Ansteuern des OLED Displays (A, O, K) mittels der pulsweitenmodulierte Gleichspannung;
Selektieren einer Empfangselektrode (EL) und Messen der eingekoppelten Spannung über eine ausgewählte Anzahl von Spannungszyklen der pulsweitenmodulierte Gleichspannung.

## Claims

1. An OLED interface, comprising:
- a screen layer (GL),
- an OLED display arranged on a first side of the screen layer (GL), comprising:
- an anode electrode layer (A),
- a cathode electrode layer (K), and
- an organic luminant layer configuration (O) incorporated between the anode electrode layer (A) and the cathode electrode layer (K), wherein the OLED display is operated by a pulse width modulated direct current voltage fed to the anode layer (A) and the cathode layer (K),
- a sensor electrode arrangement comprising a plurality of receiving electrodes (EL), which are arranged on a side of the screen layer (GL) opposing the first side; and
- an evaluation circuit (PU; 10), which is coupled with the receiving electrodes (EL),
- **characterized in that**
the evaluation circuit (PU; 10) is formed and connected such, that in cooperation with at least the anode electrode layer (A) and/or the cathode electrode layer (K) a sensor system is implemented, wherein a coupling potential of the pulse width modulated direct current voltage fed to the OLED display (A, O, K) is measured by means of the receiving electrodes (EL) and is used for touchless detection of a finger (4) or a hand of a user in an area in front of the screen layer (GL).

2. The OLED interface of claim 1, **characterized in that** the position determination is carried out by evaluating voltage levels, wherein these voltage levels are measured by means of a high impedance amplifier circuit between one of the electrode layers (A, K) and a sensor electrode arrangement (EL).

3. The OLED interface of claim 1, **characterized in that** the position determination is carried out by evaluating voltage levels, wherein these voltage levels are measured by means of a high impedance amplifier circuit between the anode electrode layer (A) and a sensor electrode arrangement (EL, 2).

4. The OLED interface of one of the preceding claims, wherein the sensor electrode arrangement is subdivided in a plurality of electrode segments (2) and these electrode segments (2) thereby form a segment array comprising segment rows and segment columns.

5. The OLED interface of claim 4, **characterized in that** the evaluation circuit (10) is configured such, that it can adopt a state of operation in which a touch detection is processed across the electrode segments (2) of the electrode layer.

6. The OLED interface of claim 5, **characterized in that** a changeover between the state of operation for position detection at contact and the state of operation for position or movement detection without contact is carried out by means of a multiplexer device.

7. The OLED interface of claim 6, **characterized in that** the clock pulse portion for adopting the operating state for position or movement detection without contact is set to zero, or is reduced, as long as a contact is detected.

8. The OLED interface of claim 6 or 7, **characterized in that** the clock pulse portion for adopting the operating state for position determination upon interface contact is reduced, as long as no contact is detected and/or that in the context of the state of operation provided for position or movement detection without contact initially a rough approach detection is carried out, and that only upon detection of a sufficiently distinct state of approach a more sensitive position determination is carried out.

9. The OLED interface of at least one of claims 1 to 8, **characterized in that** in the context of the state of operation provided for position or movement detection without contact varying electrode segment groups (S1 ... S9; Z1 ... Z5) act as sensor electrodes (EL).

10. The OLED interface of at least one of claims 1 to 9, **characterized in that** in the context of the state of operation provided for position or movement detection for determining a Y position an electrode segment group (Z1) is enabled, which represents an upper horizontal segment chain and/or that in the context of the state of operation provided for position or movement detection for determining a Y position an electrode segment group (Z5) is enabled, which represents a lower horizontal segment chain.

11. The OLED interface of at least one of claims 1 to 10, **characterized in that** in the context of the state of operation provided for position or movement detection for determining a X position an electrode segment group is enabled, which represents a left vertical segment chain (S1) and an electrode segment group is enabled, which represents a right vertical segment chain (S9).

12. The OLED interface of at least one of claims 1 to 11, **characterized in that** in the context of the state of operation provided for position or movement detection without contact for determining a X and Y position, level values are used, which are gathered form electrode segment groups aligned transversely with respect to each other, particularly being arranged perpendicularly with respect to each other.

13. The OLED interface of at least one of claims 1 to 12, **characterized in that** the electrode segment groups (Z1 ... Z5; S1 ... S9) used for detecting the finger position in the non-touch mode are interchanged adaptively, e.g. are rotated successively such that the respective enabled electrode segment group (Z1 ... Z5; S1 ... S9) moves across the interface in the manner of a moving row or a moving column.

14. The OLED interface of at least one of claims 1 to 13, **characterized in that** in the context of the state of operation provided for position or movement detection without contact two electrode segment groups are formed respectively, and the capacitive coupling of these two electrode segment groups is detected, and from this capacitive coupling the state of approach is determined.

15. A method for generating input signals in connection with the movement of a finger of a user by means of an OLED interface according to one of the preceding claims, comprising the steps of:
driving the OLED display (A, O, K) by means of the pulse width modulated direct current voltage;
selecting a receiving electrode (EL) and measuring the coupled voltage by means of a selected number of voltage cycles of the pulse width modulated direct current voltage.

## Revendications

1. Interface à OLED avec :
- une couche de vitre (GL),
- un affichage OLED disposé sur un premier côté de la couche de vitre (GL), comprenant :
- une couche d'électrode d'anode (A),
- une couche d'électrode de cathode (K) et
- une structure en couche de moyens d'éclairage (O) qui est logée entre la couche d'électrode d'anode (A) et la couche d'électrode de cathode (K), l'affichage OLED étant contrôlé par l'intermédiaire d'une tension continue modulée en largeur d'impulsion appliquée à la couche d'anode (A) et à la couche de cathode (K),
- un dispositif à électrodes de capteur avec une pluralité d'électrodes de réception (EL) qui sont disposées sur un côté opposé au premier côté de la couche de vitre (GL) ; et
- un circuit d'analyse (PU ; 10) qui est couplé avec les électrodes de réception (EL),
**caractérisée en ce que**
le circuit d'analyse (PU ; 10) est conçu et connecté de façon à ce que, en interaction avec au moins une de la couche d'électrode d'anode (A) et/ou la couche d'électrode de cathode (K), un système de capteur soit réalisé, une application de potentiel de la tension continue modulée par largeur d'impulsion appliquée à l'affichage OLED (A, O, K) étant mesurée par l'intermédiaire des électrodes de réception (EL) et permet la détection sans contact d'un doigt (4) ou d'une main d'un utilisateur dans une zone placée devant la couche de vitre (GL).

2. Interface OLED selon la revendication 1, **caractérisée en ce que** la détermination de position est effectuée grâce à l'analyse de niveaux de tension, ces niveaux de tension étant mesurés entre une des couches d'électrodes (A, K) et un dispositif à électrodes de capteur (EL) au moyen d'un circuit amplificateur à haute impédance.

3. Interface OLED selon la revendication 1, **caractérisée en ce que** la détermination de position est effectuée grâce à l'analyse de niveaux de tension, ces niveaux de tension étant mesurés entre la couche d'électrode d'anode (A) et un dispositif à électrodes de capteur (EL, 2) au moyen d'un circuit amplificateur à haute impédance.

4. Interface OLED selon l'une des revendications précédentes, le dispositif à électrodes de capteur étant divisé en une pluralité de segments d'électrodes (2) et ces segments d'électrodes (2) formant une matrice de segments qui comprend des lignes de segments et des colonnes de segments.

5. Interface OLED selon la revendication 4, **caractérisée en ce que** le circuit d'analyse (10) est conçu de façon à pouvoir adopter un état de commutation dans lequel une détection de contact est effectué par l'intermédiaire des segments d'électrodes (2) de la couche d'électrodes.

6. Interface OLED selon la revendication 5, **caractérisée en ce qu'**une commutation entre l'état de commutation pour la détection de position lors d'un contact et l'état de commutation pour la détection de position ou de mouvement sans contact est effectuée par un dispositif de multiplexage.

7. Interface OLED selon la revendication 6, **caractérisée en ce que** la partie de cadencement pour l'adoption de l'état de fonctionnement pour la détection de position ou de mouvement sans contact est réglée à zéro ou est réduite tant qu'un contact est détecté.

8. Interface OLED selon la revendication 6 ou 7, **caractérisée en ce que** la partie de cadencement pour l'adoption de l'état de fonctionnement pour la détection de position est réduite lors d'une mise en contact avec l'interface, tant qu'un contact est détecté et/ou **en ce que**, dans le cadre de l'état de commutation prévu pour la détection sans contact de position ou de mouvement, une détection d'approche grossière est d'abord effectuée et **en ce qu'**une détermination de position plus sensible n'est effectuée que lors de la détection d'un état d'approche suffisant.

9. Interface OLED selon l'une des revendications 1 à 8, **caractérisée en ce que**, dans le cadre de l'état de commutation prévu pour la détection sans contact de position ou de mouvement, des groupes de segments d'électrodes alternés (S1...S9 ; Z1...Z5) fonctionnent comme des électrodes de capteur (EL).

10. Interface OLED selon au moins l'une des revendications 1 à 9, **caractérisée en ce que**, dans le cadre de l'état de commutation prévu pour la détection sans contact de position ou de mouvement, pour la détermination d'une position Y, un groupe de segments d'électrodes (Z1) est activé, qui représente une chaîne de segments horizontale supérieure et/ou **en ce que**, dans le cadre de l'état de commutation prévu pour la détection sans contact de position ou de mouvement, pour la détermination d'une position Y, un groupe de segments d'électrodes (Z5) est activé, qui représente une chaîne de segments horizontale inférieure.

11. Interface OLED selon au moins l'une des revendications 1 à 10, **caractérisée en ce que**, dans le cadre de l'état de commutation prévu pour la détection sans contact de position ou de mouvement, pour la détermination d'une position X, un groupe de segments d'électrodes est activé, qui représente une chaîne de segments verticale gauche (S1) et un groupe de segments d'électrodes est activé, qui représente une chaîne de segments verticale droite (S9).

12. Interface OLED selon au moins l'une des revendications 1 à 11, **caractérisée en ce que**, dans le cadre de l'état de commutation prévu pour la détection sans contact de position ou de mouvement, pour la détermination de positions X et Y, il est fait référence à des valeurs de niveaux qui sont collectés à partir de groupes de segments d'électrodes orientés transversalement entre eux, plus particulièrement perpendiculaires entre eux.

13. Interface OLED selon au moins l'une des revendications 1 à 12, **caractérisée en ce que** les groupes de segments d'électrodes (Z1...Z5 ; S1...S9) pour la détection de position des doigts, dans le mode sans contact, sont interchangés de manière adaptative, par exemple sont changés successivement de façon à ce que le groupe de segments d'électrode (Z1...Z5 ; S1...S9) actif se déplace sur l'interface à la manière d'une ligne ou d'une colonne mobile.

14. Interface OLED selon au moins l'une des revendications 1 à 13, **caractérisée en ce que**, dans le cadre de l'état de commutation prévu pour la détection sans contact de position ou de mouvement, deux groupes de segments d'électrodes sont formés et le couplage capacitif de ces deux groupes de segments d'électrodes est détecté et, à partir de ce couplage capacitif, l'état d'approche est déterminé.

15. Procédé de génération de signaux d'entrée en lien avec le mouvement d'un doigt d'un utilisateur au moyen d'une interface OLED selon l'une des revendications précédentes, avec les étapes suivantes :
contrôle de l'affichage OLED (A, O, K) au moyen de la tension continue modulée en largeur d'impulsion ;
sélection d'une électrode de réception (EL) et mesure de la tension appliquée par l'intermédiaire d'un nombre sélectionné de cycles de tension de la tension continue modulée en largeur d'impulsion.
